# EUROPEAN PATENT APPLICATION

(11) **EP 4 539 048 A1**
(43) Date of publication of application: **16.04.2025**
(21) Application number: 24205326.2
(22) Date of filing: 08.10.2024
(51) Int. Cl.: G11C 5/02, G11C 7/18, G11C 8/10, G11C 8/14, G11C 11/408, G11C 11/418

(54) **MEMORY AND METHOD OF ACCESSING THE MEMORY**

(30) Priority: 12.10.2023 IN 202311068661
(71) Applicant: NXP B.V., 5656 AG Eindhoven (NL)
(72) Inventor: Singh, Jainendra, 5656AG Eindhoven (NL); Kohli, Rajat, 5656AG Eindhoven (NL); Bhat, Ganesh, 5656AG Eindhoven (NL); Mishra, Jwalant Kumar, 5656AG Eindhoven (NL)
(74) Representative: Miles, John Richard

(57) **Abstract**

A memory includes at least one memory bank which includes a set of memory arrays. Each memory cell includes a plurality of memory cells. The at least one memory bank includes: multiple word lines each connected to a corresponding row of the memory cells; a first decoder configured to receive address data, and decode the address data to provide intermediate data; a second decoder located in a central area of the memory bank between ones of the set of memory arrays, and configured to receive the intermediate data from the first decoder, and decode the intermediate data to provide selection data to the word lines. Memory cells addressable by a respective word line designated by the selection data are configured to be addressable by means of that selection data.

## Description

### BACKGROUND

The present disclosure relates to a memory and a method of accessing the memory.

A memory includes multiple cells arranged in an array, and a decoder which receives address signals and decodes the address signals to locate the memory cell to be accessed. Dynamic power, which is the power consumption of a circuit in its active operation mode, is one of the major concerns with the circuits. Memory circuits employing decoder for decoding and addressing consumes significant amount of power, and is desirable to be reduced.

### SUMMARY

This summary is provided to introduce a selection of concepts in a simplified form that are further described below in the Detailed Description. This summary is not intended to identify key or essential features of the claimed subject matter, nor is it intended to be used to limit the scope of the claimed subject matter.

In one embodiment, a memory includes at least one memory bank which includes a set of memory arrays. Each memory cell includes a plurality of memory cells. The at least one memory bank includes: multiple word lines each connected to a corresponding row of the memory cells; a first decoder configured to receive address data, and decode the address data to provide intermediate data; a second decoder located in a central area of the memory bank between ones of the set of memory arrays, and configured to receive the intermediate data from the first decoder, and decode the intermediate data to provide selection data to the word lines. Memory cells addressable by a respective word line designated by the selection data are configured to be addressable by means of that selection data.

In an embodiment, there is provided a method of accessing a memory including at least one memory bank. The method includes: receiving, at a first decoder, address data for accessing the memory; the at least one memory bank of the memory comprises a set of memory arrays each comprising a plurality of memory cells; decoding, by the first decoder, the address data, to provide intermediate data; receiving, by a second decoder located in a central area of the memory bank between ones of the set of memory arrays, the intermediate data from the first decoder; and decoding, by the second decoder, the intermediate data, to provide selection data to word lines each connected to a corresponding row of the memory cells. Enabling at least one of read or write access to the row of the memory cells connected to the word line designated by the selection data.

In some embodiments, the memory bank comprises eight memory arrays arranged in an array of 2 columns by 4 rows, and wherein the first decoder is placed at an edge of the memory bank between 2 columns of memory arrays, and the second decoder is placed between the second and third rows of the 4-row memory arrays. In some embodiments, each memory array comprises 8 rows each having 2048 memory cells.

In some embodiments, the decoding, by the first decoder, the address data, to provide intermediate data comprises decoding predetermined bits of the address data, the predetermined bits are less in number than a total number of bits of the address data.

In some embodiments, decoding, by the first decoder, the address data, to provide intermediate data comprises: at multiple sub-decoders of the first decoder, decoding segmented bits of the address data.

In some embodiments, the sub-decoder of the first decoder is selected from a 2-to-4 decoder and a 3-to-8 decoder.

In some embodiments, the decoding, by the second decoder, the intermediate data, to provide selection data comprises providing the selection data as a one-hot code decoded from the address data.

In some embodiments, the method further comprises: receiving, at a column multiplexer, column address data; accessing a one of the row of memory cells designated by the selection data, in response to the column address data.

In some embodiments, The method further comprises: receiving, at a column decoder, column address data; decoding, by the column decoder, the column address data, to provide column selection data to bit lines each connected to a corresponding column of the memory cells; and enabling at least one of read or write access to the column of the memory cells connected to the bit line designated by the column selection data. In some embodiments, the method further comprises receiving, at the first decoder, control data; decoding, by the first decoder, the control data, to control operation of the memory bank.

### BRIEF DESCRIPTION OF THE DRAWINGS

So that the manner in which the above recited features of the present disclosure can be understood in detail, a more detailed description of the disclosure may be had by reference to embodiments, some of which are illustrated in the appended drawings. The appended drawings illustrate only typical embodiments of the disclosure and should not limit the scope of the disclosure, as the disclosure may have other equally effective embodiments. The drawings are for facilitating an understanding of the disclosure and thus are not necessarily drawn to scale. Advantages of the subject matter claimed will become apparent to those skilled in the art upon reading this description in conjunction with the accompanying drawings, in which like reference numerals have been used to designate like elements, and in which:
Fig. 1 is a block diagram of a memory bank according to an embodiment;
Fig. 2 is a schematic diagram of a memory cell;
Fig. 3 is a block diagram of the first decoder of Fig. 1 according to an embodiment;
Fig. 4 is a block diagram of a memory bank according to an embodiment;
Fig. 5 is a block diagram of an I/O interface according to an embodiment;
Fig. 6 is a block diagram of a memory array according to an embodiment;
Fig. 7 is a flow diagram of a method of accessing a memory according to an embodiment;
Fig. 8 is a flow diagram of a method of accessing a memory according to an embodiment;
Fig. 9 is a flow diagram of a method of accessing a memory according to an embodiment; and
Fig. 10 is a flow diagram of a method of accessing a memory according to an embodiment.

### DETAILED DESCRIPTION

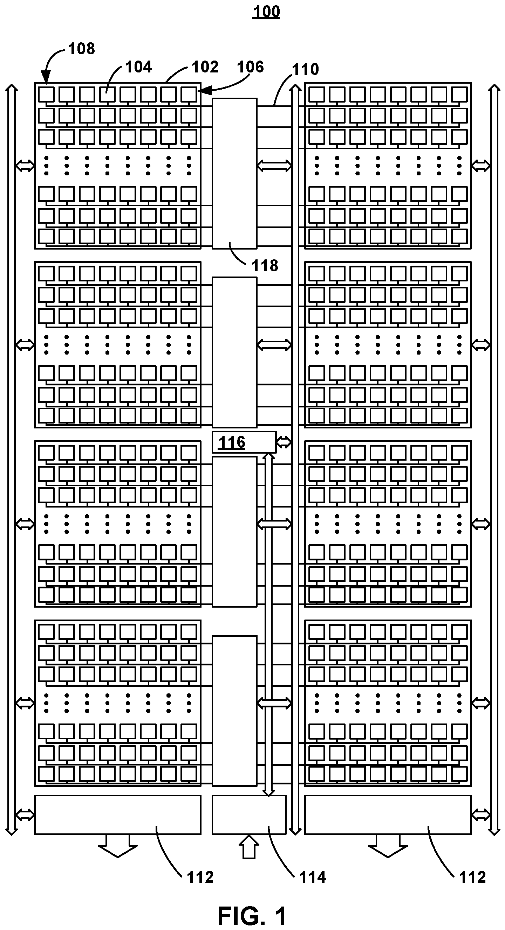

Fig. 1 is a block diagram of a memory bank according to an embodiment. The memory bank 100 may be one of multiple memory banks integrated in a memory device. A memory device may include multiple, for example 8 or more, memory banks. The memory bank 100 according to this embodiment further includes 8 memory arrays 102 that are arranged in an array of 2 columns and 4 rows. In other embodiments the memory bank 100 can include a set of other number of memory arrays.

Each memory array 102 includes a plurality of memory cells 104 each configured to store a bit of data by presenting one of the states that can be accessed and interpreted as a binary "0" or "1". The memory cell 104 can have various configurations depending on the technology. For example for a typical Dynamic Random Access Memory (DRAM) the memory cell 104 includes a transistor and a capacitor, and for a typical Static Random Access Memory (SRAM) the memory cell 104 includes 6 or 4 transistors. In the embodiment, the memory array 102 includes 8 × 2¹¹ memory cells 104 that are arranged in rows and columns. As can be seen from Fig. 1, each row 106 includes 8 memory cells 104, and each column 108 includes 2¹¹, which is 2048 (2k), memory cells 104. In other embodiments, the memory array 102 can include other number of memory cells 104, depending on the required size and area consumed.

The memory cells 104 arranged in one row 106 are all connected to a word line 110, and the memory bank 100 includes multiple word lines 110 each connected to a corresponding row 106 of memory cells 104. The memory cells 104 in a row 106 designated by the corresponding word line 110 are accessible, or addressable. For example, in a read operation, data stored in the memory cells 104 of a row 106 corresponding to a selected word line 110 is read out to an input/output (I/O) interface 112; while during a write operation, data in the I/O interface 112 is written into the memory cells 104 of the row 106.

For designating a target row of memory cells to be addressed, a first decoder 114 of the memory bank 100 is configured to receive address data, and perform a first decoding operation to provide intermediate data to a second decoder 116 of the memory bank 100. As a response to receiving the intermediate data from the first decoder 114, the second decoder 116 performs a second decoding operation, and provides selection data to a post-decoder 118. Relatively, the first decoder 114 and the second decoder 116 may be collectively referred to as a pre-decoder. The post-decoder 118 enhances driving capability of the selection data, and forwards the enhanced selection data to the word lines 110. The selection data is provided as a one-hot code which is decoded from the address data. One-hot code means, for the selection data which includes multiple bits each provided to a corresponding word line 110, only one bit is designated as active to select the corresponding row 106 of memory cells 102 to be accessible, while the other bits are inactive and their corresponding rows 106 of memory cells 102 are not selected as accessible.

As illustrated in Fig. 1, the first decoder 114 is placed at an edge area in the memory bank 100, between the two columns of memory arrays 102. The second decoder 116 is placed between the second row and the third row of memory array 102. The second decoder 116 is placed in the central area of the memory bank 100 between the set of memory arrays 102, such that travel length for the decoded selection data from the second decoder 116 to corresponding post-decoders 118 is short. The selection data is provided to pull a corresponding word line 110 up to state "1".

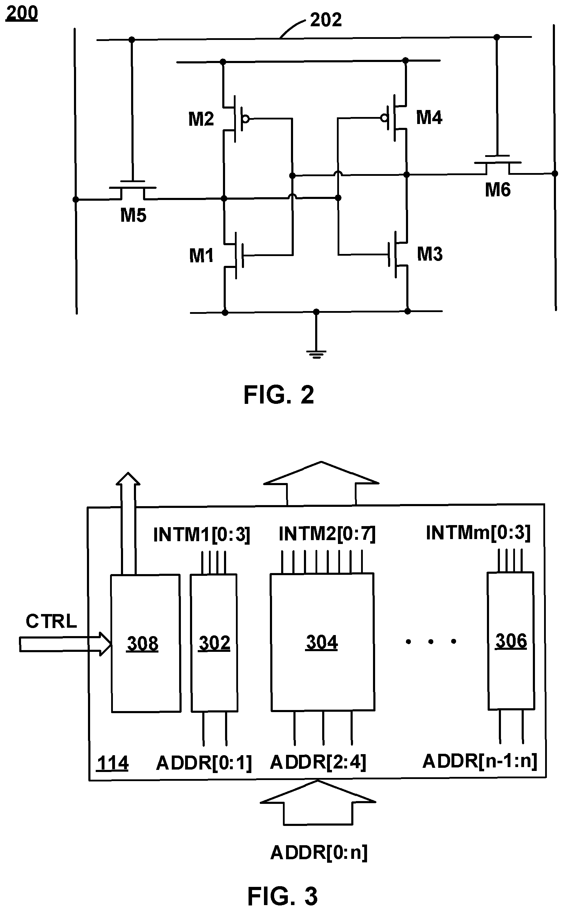

Referring to Fig. 2 which is a schematic diagram of a memory cell 200 of a SRAM type, the word line 202 is connected to gate terminals of transistors M5 and M6 such that, when the state on word line 202 is high, the memory cell 200 will be accessible, for example data stored in the two CMOS inverters, respectively including M1 and M2, or M3 and M4, will be read out in a read operation, or the CMOS inverters will be set to store a data bit. The word line 202 is connected to all the memory cells in a row, while each memory cell has two gate terminals of the NMOS transistors M5 and M6 connected to the word line 202. Because of the heavy gate load present at the gate terminals, pulling up the word line 202 to a high state is both time and power consuming, as the potential toggling capacitance increases setup time and toggle power. The second decoder 116 according to the embodiment provides the selection data to the word lines 110 with an economic and relatively short travel length, which minimizes the RC delay for the selection data.

Referring back to Fig. 1, the first decoder 114 provides the intermediate data to the second decoder 116 also with an economic travel length, and the first decoder 114 consumes time and power only for decoding the received address data; the load, that is to say the cause of the time and power consumption, for the first decoder 114 is mainly due to the resistance of the metal routing between the first decoder 114 and the second decoder 116; this is referred to as metal load.

Fig. 3 is a block diagram of the first decoder 114 of Fig. 1. The first decoder 114 according to the embodiment includes more than one sub-decoder. Fig. 3 illustrates three sub-decoders 302, 304, and 306 of the first decoder 114, however the first decoder 114 may include a different number of sub-decoders. In the embodiment shown in Fig. 3, the first sub-decoder 302 decodes the first two bits ADDR[0:1] of the received n-bit address data ADDR[0:n], and provides the 4-bit decoded intermediate data INTM1[0:3]. The second sub-decoder 304 decodes 3 bits ADDR[2:4] of the address data ADDR[0:n] following the first two bits ADDR[0:1] that has been provided to the first sub-decoder 302, and provides the 8-bit decoded intermediate data INTM2[0:7]. The third sub-decoder 306 decodes the last 2 bits ADDR[n-1:n] of the address data ADDR[0:n], and provides the 4 bit decoded intermediate data INTMm[0:3]. In general, the first decoder 114 includes multiple sub-decoders, which each decodes segmented bits of the address data ADDR[0:n], until all the bits in the address data ADDR[0:n] are decoded. The sub-decoders 302, 304, 306 can each be a 2-to-4 decoder (that is to say, a decoder which decodes 2 bits resulting in 4 possible values), a 3-to-8 decoder (that is to say, a decoder which decodes 3 bits resulting in 8 possible values), or any other applicable small scale decoders.

According to the embodiment, the first decoder 114 includes a controlling unit 308 which receives a control signal, and provides corresponding control data to the decoders and memory arrays. The control signal may contain information on clock, chip enablement, etc. In other embodiments, if the address data includes particular bits, for example one or more bits that designates the memory array to be addressed, the first decoder 114 may forward such particular bits to the second decoder, such that the first decoder 114 only decodes those bits in the address data that are less than a total number of bits of the address data. That is to say, the first decoder 114 does not fully decode the address data.

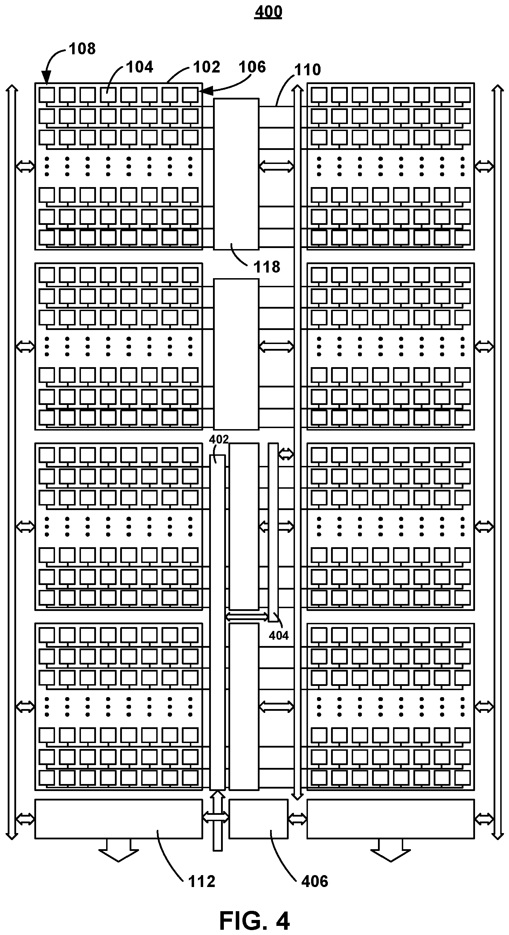

Fig. 4 is a block diagram of a memory bank according to another embodiment. The memory bank of Fig. 4 is similar to the memory bank of Fig. 1, with similar parts labelled similarly, except that the first decoder 402 is configured in the memory bank 400 between the columns of memory arrays 102 and near an edge side of the memory bank 400. The first decoder 402 extends along the first and second row of memory array 102. In the embodiment, the second decoder 404 is configured in the memory bank 400 in a central area and between the two columns of memory arrays 102, however it is nearer the second row of memory arrays 102 than is the first decoder 402.

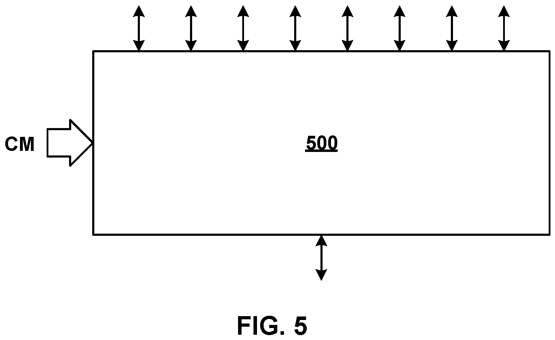

Fig. 5 is a block diagram of the I/O interface of the memory bank according to an embodiment. The memory bank including the I/O interface 500 is addressable in the unit of bits, which means a single bit of data for a single memory cell is accessible. Designated by the address data targeting a row of memory cells, the I/O interface 500 is ready for addressing a particular row of memory cells. The I/O interface 500 further receives column multiplexer data CM, and designate a particular memory cell in the row to be addressed, i.e. to read from or to write to. The I/O interface 500 may include a column multiplexer for selecting the bit from the 8-bit word.

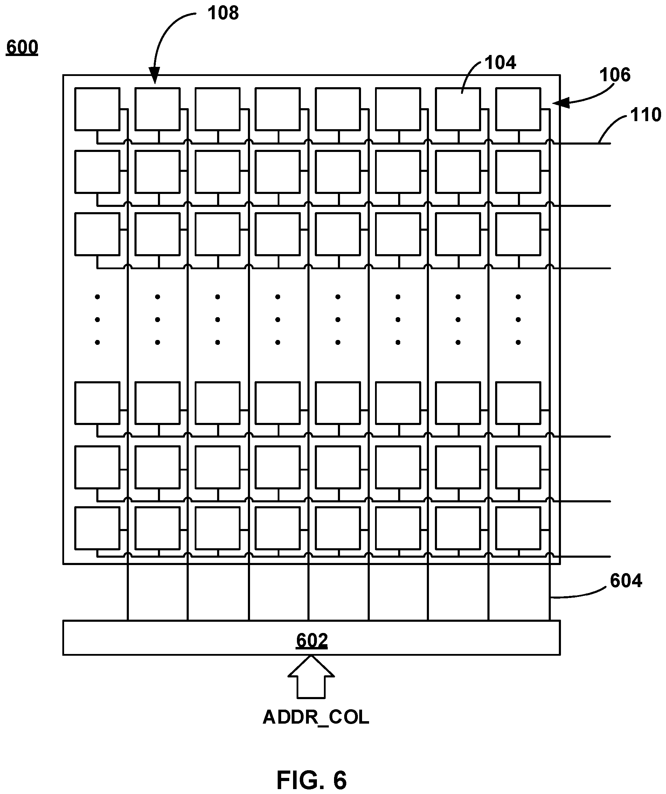

Fig. 6 is a block diagram of a memory array according to an embodiment. The memory array 600 is similar to the memory arrays of Fig. 1 and Fig. 4, including the memory cells 104 arranged in an array, and multiple word lines 110 for addressing a row of the memory cells 104. The memory array 600 includes a column decoder 602 which receives column address data ADDR_COL, and decodes to provide column selection data to bit lines 604 of the memory array 600. Memory cells 104 in a column 108 designated by the column selection data are accessible. In other embodiments, the column decoder is global to all memory arrays, and designates a unique column of memory cells in the memory bank to be accessible.

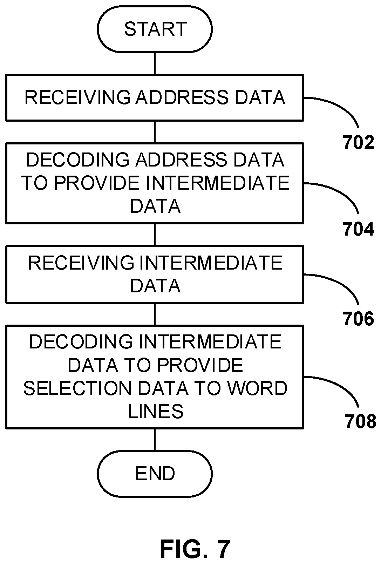

Fig. 7 is a flow diagram of a method of accessing a memory according to an embodiment. The method will be described with reference to the embodiments of Figs. 1 to 6. At step 702, the first decoder 114 receives address data for addressing the memory. The first decoder 114 is placed, or located, at an edge area in the memory bank between the two columns of memory arrays 102. At step 704, the first decoder 114 decodes the address data, to provide the intermediate data. At step 706, the second decoder 116 of the pre-decoder receives the intermediate data from the first decoder 114. The second decoder 116 is located in a central area of the memory bank between the set of memory arrays 102. At step 708, the second decoder 116 decodes the intermediate data to provide selection data to the word lines 110. The memory cells 104 in the row 106 designated by the selection data through the corresponding word line 110 are accessible.

The step 702 in which the first decoder 114 decodes the address data to provide the intermediate data includes decoding bits of the address data less than a total number of bits of the address data. In other embodiments, the step 702 in which the first decoder 114 decodes the address data includes the multiple sub-decoders of the first decoder decoding the segmented bits of the address data. The sub-decoders are 2-to-4 decoder, 3-to-8 decoder, or other applicable small scale decoders.

The step 708 in which the second decoder 116 decodes the intermediate data to provide the selection data includes providing the selection data as the one-hot code which is decoded from the address data. The skilled person will appreciate that the term "one-hot code" refers to an indication of a single word line which is active, that is to say enabled or "hot", in order to allow memory cells in the row connected to that word line to be accessed or addressed for read and/or write operations.

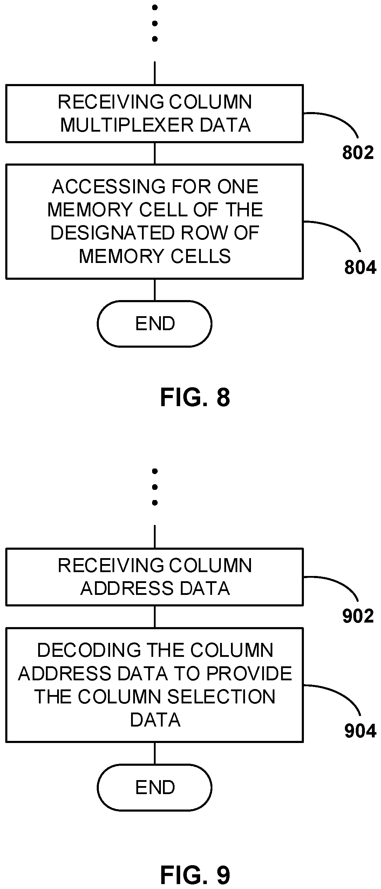

Fig. 8 is a flow diagram of accessing a memory according to an embodiment. Steps of Fig. 8 may be implemented as additional to those in Fig. 7, to provide bit-wise access to the memory. The method of Fig. 8 can be described with reference to Fig. 5. At step 802, the column multiplexer of the I/O interface 500 receives the column multiplexer data CM. At step 804, in response to the column multiplexer data CM, one memory cells in the row of memory cells already designated by the selection data is accessible.

Fig. 9 is a flow diagram of accessing a memory according to an embodiment. Steps of Fig. 9 may be implemented as additional to those of Fig. 7, to provide bit-wise access to the memory. The method of Fig. 9 can be described with reference to Fig. 6. At step 902, the column decoder 602 receives the column address data. At step 904, the column decoder 602 decodes the column address data, to provide the column selection data to the bit lines 604. Each bit line 604 is connected to a corresponding column 108 of the memory cells 104. Memory cells 104 designated by the column selection data through the corresponding bit line 604 are accessible.

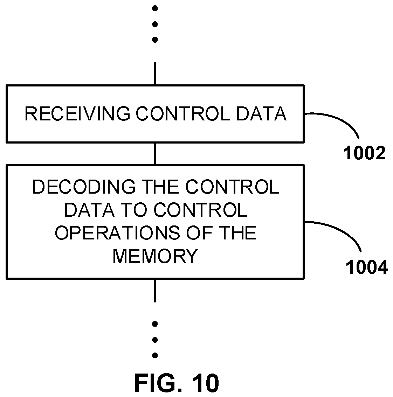

Fig. 10 is a flow diagram of accessing a memory according to an embodiment. Steps of Fig. 10 may be implemented as additional to those of Fig. 7. At step 1002, the first decoder 114 receives the control data. At step 1004, the first decoder 114 decodes the control data to control the operations of the memory bank 100.

The described embodiments take example of SRAM memory cells, however various types of memory cells are within the range of the present disclosure. In various embodiments, the memory includes one or more DRAM cells, applicable Random Access Memory (RAM), Erasable Programmable Read Only Memory (EPROM), One-Time-Programmable (OTP) memory units, Flash, eFuse, etc.

A memory includes at least one memory bank which includes a set of memory arrays. Each memory cell includes a plurality of memory cells. The at least one memory bank includes: multiple word lines each connected to a corresponding row of the memory cells; a first decoder configured to receive address data, and decode the address data to provide intermediate data; a second decoder located in a central area of the memory bank between ones of the set of memory arrays, and configured to receive the intermediate data from the first decoder, and decode the intermediate data to provide selection data to the word lines. Memory cells addressable by a respective word line designated by the selection data are configured to be addressable by means of that selection data.

The use of the terms "a" and "an" and "the" and similar referents in the context of describing the subject matter (particularly in the context of the following claims) are to be construed to cover both the singular and the plural, unless otherwise indicated herein or clearly contradicted by context. The terms "coupled" and "connected" both mean that there is an electrical connection between the elements being coupled or connected, and neither implies that there are no intervening elements. In describing transistors and connections thereto, the terms gate, drain and source are used interchangeably with the terms "gate terminal", "drain terminal" and "source terminal". Recitation of ranges of values herein are intended merely to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims set forth hereinafter together with any equivalents thereof entitled to. The use of any and all examples, or exemplary language (e.g., "such as") provided herein, is intended merely to better illustrate the subject matter and does not pose a limitation on the scope of the subject matter unless otherwise claimed. The use of the term "based on" and other like phrases indicating a condition for bringing about a result, both in the claims and in the written description, is not intended to foreclose any other conditions that bring about that result. No language in the specification should be construed as indicating any non-claimed element as essential to the practice of the disclosure as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law. Moreover, any combination of the above-described elements in all possible variations thereof is encompassed unless otherwise indicated herein or otherwise clearly contradicted by context.

## Claims

1. A memory comprising at least one memory bank comprising a set of memory arrays each comprising a plurality of memory cells; wherein the at least one memory bank comprises:
multiple word lines each connected to a corresponding row of the memory cells;
a first decoder configured to receive address data, and decode the address data to provide intermediate data; and
a second decoder located in a central area of the memory bank between ones of the set of memory arrays, and configured to receive the intermediate data from the first decoder, and decode the intermediate data to provide selection data to the word lines;
wherein memory cells addressable by a respective word line designated by the selection data are configured to be addressable by means of that selection data.

2. The memory of claim 1, wherein the memory bank comprises eight memory arrays arranged in an array of 2 columns by 4 rows, and wherein the first decoder is placed at an edge of the memory bank between 2 columns of memory arrays, and the second decoder is placed between the second and third rows of the 4-row memory arrays.

3. The memory of any preceding claim, wherein each memory array comprises 8 rows each having 2048 memory cells.

4. The memory of any preceding claim, wherein the first decoder is configured to decode predetermined bits of the address data, wherein the predetermined bits are less in number than a total number of bits of the address data.

5. The memory of any preceding claim, wherein the first decoder comprises multiple sub-decoders each configured to decode segmented bits of the address data.

6. The memory of claim 5, wherein the sub-decoder of the first decoder is selected from a 2-to-4 decoder and a 3-to-8 decoder.

7. The memory of any preceding claim, wherein the second decoder is configured to provide the selection data as a one-hot code decoded from the address data.

8. The memory of any preceding claim, wherein each memory bank further comprises a column multiplexer configured to access a one of the row of memory cells designated by the selection data, in response to a column address data.

9. The memory of any preceding claim, wherein each memory bank further comprises:
multiple bit lines each connected to a corresponding column of the memory cells;
a column decoder configured to receive column address data and decode to provide column selection data to the bit lines; wherein memory cells addressable by a respective bit line designated by the column selection data are configured to be addressable by means of that column selection data.

10. The memory of any preceding claim, wherein the first decoder is further configured to receive control data, and decode the control data to control operation of the memory bank.

11. A method of accessing a memory comprising at least one memory bank, the method comprising:
receiving, at a first decoder, address data for accessing the memory; wherein the at least one memory bank of the memory comprises a set of memory arrays each comprising a plurality of memory cells;
decoding, by the first decoder, the address data, to provide intermediate data;
receiving, by a second decoder located in a central area of the memory bank between ones of the set of memory arrays, the intermediate data from the first decoder; and
decoding, by the second decoder, the intermediate data, to provide selection data to word lines each connected to a corresponding row of the memory cells; and
enabling at least one of read or write access to the row of the memory cells connected to the word line designated by the selection data.

12. The method of claim 11, the memory bank comprises eight memory arrays arranged in an array of 2 columns by 4 rows, and wherein the first decoder is placed at an edge of the memory bank between 2 columns of memory arrays, and the second decoder is placed between the second and third rows of the 4-row memory arrays.

13. The method of claim 11 or 12, wherein each memory array comprises 8 rows each having 2048 memory cells.

14. The method of any of claims 11 to 13, wherein the decoding, by the first decoder, the address data, to provide intermediate data comprises decoding predetermined bits of the address data, the predetermined bits are less in number than a total number of bits of the address data.

15. The method of any of claims 11 to 14, wherein decoding, by the first decoder, the address data, to provide intermediate data comprises: at multiple sub-decoders of the first decoder, decoding segmented bits of the address data.
